(19) Europäisches Patentamt / European Patent Office / Office européen des brevets

(11) **EP 4 414 785 A1**

(12) **EUROPEAN PATENT APPLICATION**

(43) Date of publication:
**14.08.2024 Bulletin 2024/33**

(21) Application number: **23156294.3**

(22) Date of filing: **13.02.2023**

(51) International Patent Classification (IPC):
**G03F 7/00** (2006.01)

(52) Cooperative Patent Classification (CPC):
**G03F 7/706849; G03F 7/70625**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
- **VAN DER POST, Sietse, Thijmen**
  **5500 AH Veldhoven (NL)**
- **EDWARD, Stephen**
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD WITH BEAMS INCIDENT ON A TARGET AT A PLURALITY OF DIFFERENT ANGLES OF INCIDENCE AND ASSOCIATED METROLOGY TOOL**

(57) Disclosed is a metrology method and metrology tool comprising a first dispersive element (810) operable to receive and scatter source radiation (e.g., hard X-ray, soft X-ray (SXR) or extreme ultraviolet radiation (EUV)) so as to generate first scattered radiation; a final focusing element (815) (e.g., a first grating) being configured to: collect at least a portion of the first scattered radiation, the collected first scattered radiation comprising a plurality of first scattered beams (e.g., of different diffraction orders (m=-1, m=0, m=+1)), each having been scattered in a respective different direction; and focus the collected first scattered radiation on a second dispersive element (e.g., a target being measured, such as a second (target) grating) (820) such that each of the first scattered beams is incident on the second dispersive element (820) at a respective different angle of incidence; and at least one detector (825) operable to detect second scattered radiation (e.g., of different diffraction orders (-1,+1; -1,0; 0,0; +1,-1; +1,0)) having been scattered by the second dispersive element (820). At least one pair of second scattered beams comprised within the second scattered radiation may overlap on the detector (825) to form interference fringes, wherein the metrology tool may be configured to determine a phase difference between the beams of each pair of second scattered beams from the position of respective interference fringes on the detector (825) for each pair of second scattered beams. The metrology tool may comprise a first focusing element (805) being operable to focus the source radiation at an intermediate field plane, wherein the first dispersive element (810) is located at the intermediate field plane or wherein the first dispersive element (810) is located at a defocus distance (dZ) from the intermediate field plane (IFP). Alternatively, the first dispersive element may comprise a virtual first dispersive element (1010) located at a source plane, wherein a radiation source for generating the source radiation may comprise a laser source arrangement operable to generate a pair of radiation beams (laser pulses) (1000a, 1000b) towards a gas target such that the pair of radiation beams (1000a, 1000b) overlaps temporally and spatially and at respective different angles in the gas target so as to generate an interference pattern forming the virtual first dispersive element (1010), wherein a rotatable waveplate (1050) may be provided in the path of at least one radiation beam (1000b) of the pair of radiation beams to control polarization and interference of the radiation beams (1000a, 1000b). The final focusing element (815) may comprise a final focusing mirror element, wherein the final focusing mirror element may comprise a hollow prolate spheroid portion (1100), having a reflective internal surface (1110). The metrology tool is configured to measure a parameter of interest during manufacturing process at multiple angles of incidence simultaneously.

(b)                                                                    Fig. 8

**(Cont. next page)**

1000a
1010
1040
1030+
1000b
1020
1030-
1050
(b)

Fig. 10

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-$k_1$ lithography may be used to process features with dimensions smaller than the classical resolution limit of a lithographic apparatus. In such process, the resolution formula may be expressed as CD = $k_1 \times \lambda$/NA, where $\lambda$, is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low $k_1$.

In lithographic processes, as well as other manufacturing processes, it is desirable frequently to measure parameters of interest, i.e. make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

To determine parameters of interest related to a measured target, it is desirable to maximize or increase signal diversity in the detected signal.

SUMMARY

In a first aspect of the invention, there is provided a metrology tool comprising a first dispersive element operable to receive and scatter source radiation so as to generate first scattered radiation; a final focusing element being configured to: collect at least a portion of said first scattered radiation, the collected first scattered radiation comprising a plurality of first scattered beams, each having been scattered in a respective different direction; and focus said collected first scattered radiation on a second dispersive element such that each of said first scattered beams is incident on said second dispersive element at a respective different angle of incidence; and at least one detector operable to detect second scattered radiation having been scattered by said second dispersive element.

In a second aspect of the invention, there is provided a focusing mirror element comprising a hollow prolate spheroid portion, having a mirrored internal surface and comprising: a first opening at an input end and a second opening at an output end.

In a third aspect of the invention, there is provided a method of manufacturing the focusing mirror element of the second aspect, comprising providing an axially symmetric mandrel comprising a prolate spheroid portion; forming a focusing mirror element body around the mandrel; and releasing the focusing mirror element body from the mandrel; whereby the focusing mirror element body has an optical surface defined by the internal surface of the focusing mirror element body.

In a fourth aspect of the invention, there is provided a metrology method comprising: generating source radiation; scattering the source radiation so as to generate first scattered radiation; collecting at least a portion of said first scattered radiation, the collected first scattered radiation comprising a plurality of first scattered beams, each having been scattered in a respective different direction; focusing said collected first scattered radiation on a target such that each of said first scattered beams is incident on said target at a respective different angle of incidence; and detecting second scattered radiation having been scattered by said target.

These and other aspects and advantages of the apparatus and methods disclosed herein will be appreciated from a consideration of the following description and drawings of exemplary embodiments.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figures 8(a) and 8(b) each depicts a simplified schematic of a metrology arrangement according to an embodiment;
- Figure 9 depicts an example diffraction pattern as may be captured by the metrology arrangement of Figure 8;
- Figures 10(a), 10(b) and 10(c) depict arrangements for providing a virtual grating at a source plane according to an embodiment;

- Figure 11 depicts a proposed refocusing mirror design according to an embodiment and suitable for use in the metrology arrangement of Figure 8;
- Figure 12 depicts a method for obtaining a point of origin displacement of diffraction beams from a diffraction grating, for use in a phase determination embodiment of the concepts disclosed herein;
- Figure 13 depicts how such a point of origin displacement results in a mutual wavefront tilt of the of diffraction beams of Figure 12 and therefore an optical path difference between these diffraction beams.; and
- Figure 14 is an example interference image obtained from the arrangement depicted in Figures 12 and 13.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

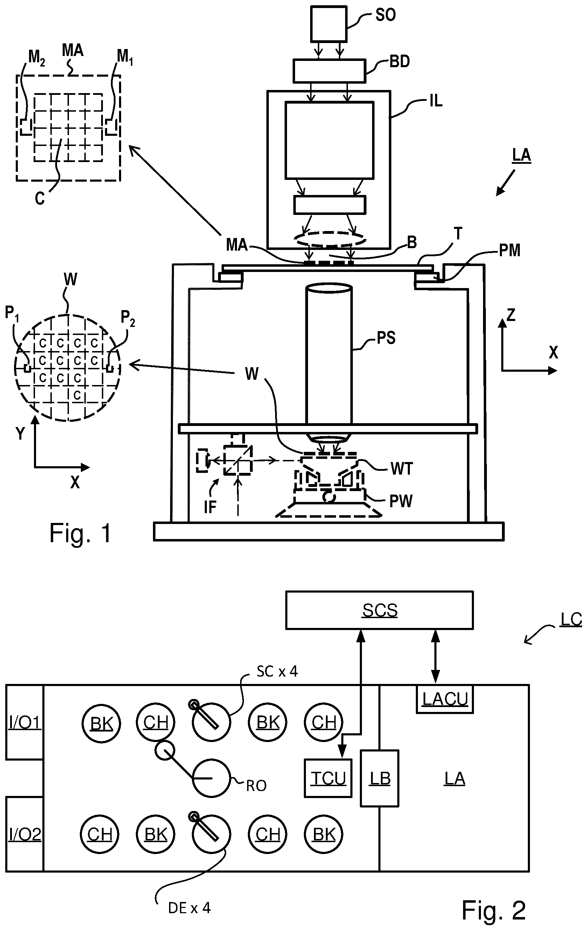

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

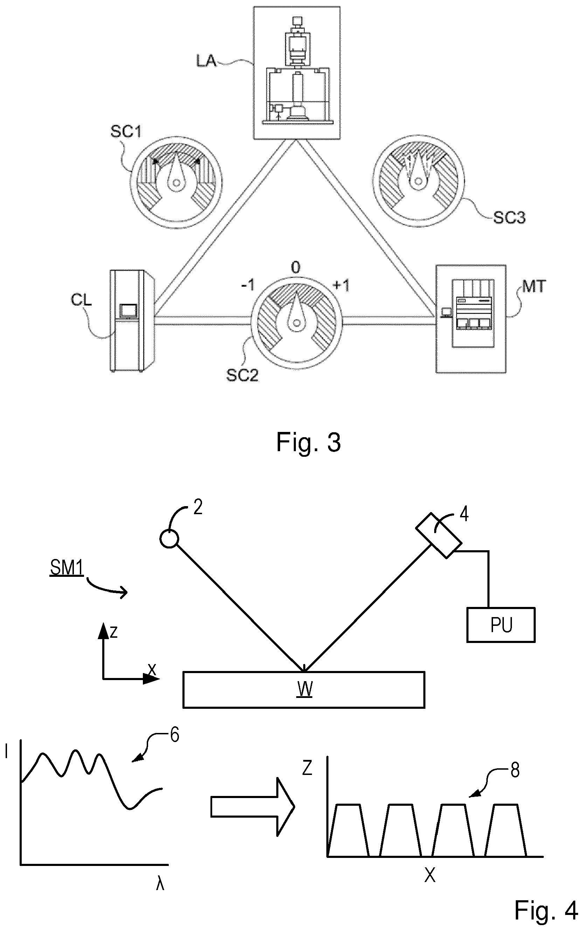

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analysing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

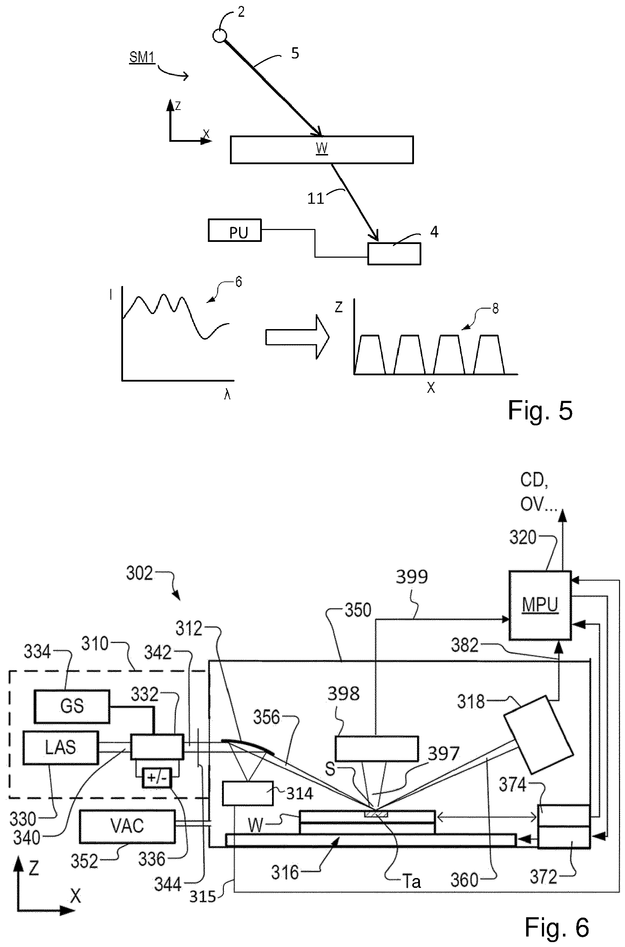

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681.

It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent applications are incorporated herein by reference in their entirety.

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to $10\mu m$, for example in the region of 1 $\mu m$ (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen ($N_2$), Oxygen ($O_2$), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 1-50 nm, 1-30 nm, 5-30 nm, or optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 20 nm, 1nm to 20nm or 10nm to 20nm), a source may use High Harmonic Generation (HHG) or any other types of sources mentioned above to obtain radiation at the desired wavelength(s).

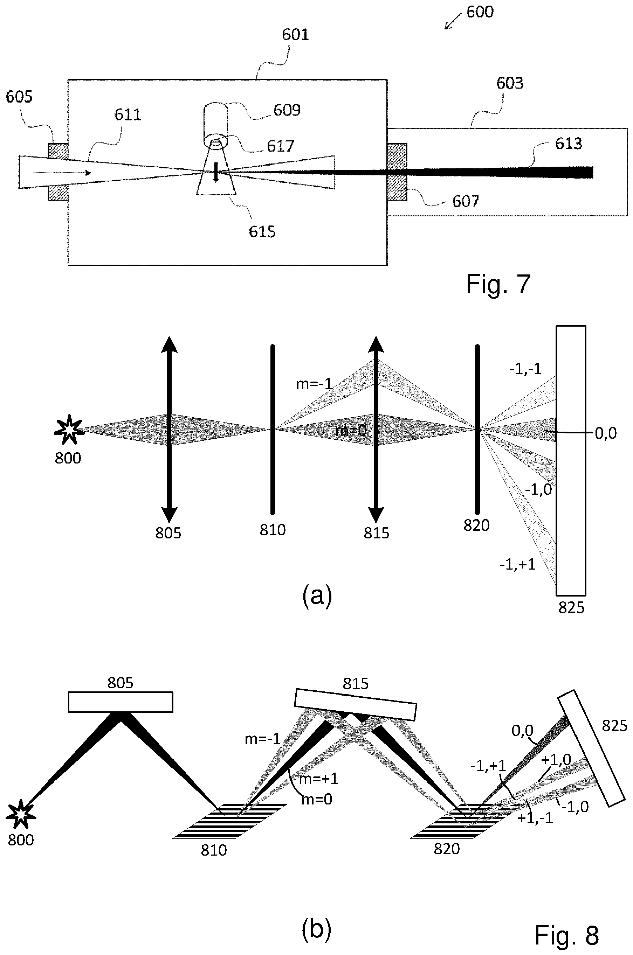

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen ($N_2$), Oxygen ($O_2$), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation.

Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, hereafter referred to as SXR radiation, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive/pump radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimize the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focused onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centered, in a Gaussian or close-to-Gaussian profile in the far field.

In the aforementioned SXR sensor/metrology configuration, a beam of SXR light may be focused under a fixed, single angle on the target by means of a (e.g., single) focusing mirror or mirror system. The intensity of the diffraction orders scattered by the target may be detected using one or more sensors close to the target. The detected light may be analyzed using algorithms that infer target parameter or parameter of interest values relating to the illuminated target. The parameters of interest may comprise, for example, overlay or (e.g., 3D) profile parameters such as etch-depth, side-wall angle (SWA), layer thickness etc.. More complex targets may comprise more than 10 or even more than 20 target parameters.

It may be that subsets of the target parameters will, to a more or lesser extent, be correlated within the detected signals, meaning that variation in each of two or more such parameters results in a similar variation in the detected signal. This means it may be difficult to disentangle the effects of these parameters and determine which parameter(s) are responsible for a particular signal effect. Also, some parameters may result in a very weak signal contribution in such a configuration, making it difficult to obtain an accurate estimation for that parameter from the measured data.

In theory, measurements at multiple angles of incidence may be used to create a larger signal diversity (see e.g., ellipsometry). However, at broadband SXR or EUV wavelengths, it is difficult and/or expensive to manufacture optics to achieve this. A simple solution (in principle) may comprise providing multiple sources and illuminators so as to provide independent incident light sources. However, this would result in a large cost and would be difficult to accommodate in a compact tool design.

To address these issues, it is proposed herein to provide a (e.g., first) dispersive element (e.g. a grating) in a conjugate (field/image) plane of the wafer-side focal plane which effectively multiplies the source beam so as to provide, optionally simultaneously, multiple angles of incidence on the target.

In a first embodiment, the proposed (e.g., SXR) metrology tool may comprise only a simple finite-finite conjugate illuminator system (e.g. a single toroidal, ellipsoidal or Kirkpatrick-Baez (KB) mirror system). In such a case, the only conjugate field plane available is the plane of the (virtual) source. In another embodiment the illuminator contains an intermediate focus at a second conjugate field plane. The conjugate field plane at the source is hereafter referred as the source field plane (SFP) and the conjugate field plane at the intermediate focus is called intermediate field plane (IFP).

In either case, first scattered radiation, having been scattered by the first dispersive element, may be captured by a (e.g., single) final focusing mirror element. The first scattered radiation comprises a plurality of scattered beams, i.e., both diffracted radiation and specularly reflected radiation. This final focusing mirror element reimages the plane comprising the first dispersive element (e.g., SFP or IFP depending on the arrangement) onto the target or second diffractive element by capturing as much as possible of the first scattered radiation. As such, the final focusing mirror element may capture and reimage the reflected radiation and at least one and preferably a plurality of (e.g., as many as possible) the diffracted orders comprised within the first scattered radiation. This reimaged first scattered radiation will therefore be incident on the target under various respective angles of incidence due to the various diffraction angles from the first dispersive element. Where the dispersed radiation is broadband or comprises multiple wavelengths, each "diffraction order" from the first dispersive element will actually comprise multiple single-color diffraction orders with color-dependent angle of incidence on the target. Second scattered radiation, having been scattered from the target or second diffractive element, may comprise the specular reflection and a plurality of diffraction orders from the target (i.e., second scattered beams); each of which can be detected and will comprise additional information when compared to a conventional measurement using a single beam at a single angle of incidence.

Figure 8 shows (a) a conceptual diagram and (b) simplified schematic diagram of an embodiment. In Figure 8(a) all beams are drawn in transmission for clarity. In Figure 8(b) the focusing elements and dispersive elements are reflective, as may be more appropriate for SXR metrology (at least for the focusing elements, the dispersive elements may operate in either reflection or transmission). Figure 8 shows a source 800, a first focusing element or first focusing mirror 805 which reimages the source 800 at an intermediate field plane comprising a first dispersive element or grating 810. Scattered radiation from the grating 810 may be captured by a second focusing element or final focusing mirror element 815, which reimages the intermediate field plane onto second dispersive element or target 820 (optionally it is the final focusing element before the target/wafer). This second refocusing element may comprise an ellipsoidal mirror comprising a particular ellipsoidal configuration, as will be described later. Second scattered radiation from the target 820 may be captured on a detector or camera 825.

In this description, the numbering convention for the captured diffraction orders will describe each captured order (m, n), where m describes the diffraction order (e.g., comprising at least the zeroth order and at least one higher diffraction order) from the first dispersive element/grating 810 and n describes the diffraction order from the second dispersive element/target 820. In conventional SXR metrology, only the m=0 orders are detected. As such, where a captured diffraction order is the +1 diffracted order from the target 820, resultant from incident radiation on the target comprising the -1 diffraction order from the grating 810, this diffraction order may be described as the (-1, +1) diffraction order. Note that the captured diffraction orders may optionally comprise higher diffraction orders than the first orders (e.g., $m \geq 2$ and/or $n \geq 2$).

In Figure 8(a), for clarity only, only the m=0 and m=-1 orders from the grating 810 are drawn for a single wavelength; other orders (both positive and negative) may be captured by the final focusing mirror also. It may be appreciated that the diffraction orders of different wavelengths are angular displaced (i.e., the diffraction angle and thus the incident angle on the target is different for different wavelengths). Again, for clarity, the only captured diffraction orders shown are (-1,-1), (0,0), (-1,0), (-1,+1). More diffraction orders may be captured. In Figure 8(b), more captured diffraction orders are shown, as labeled, although once again other diffraction orders may also be captured.

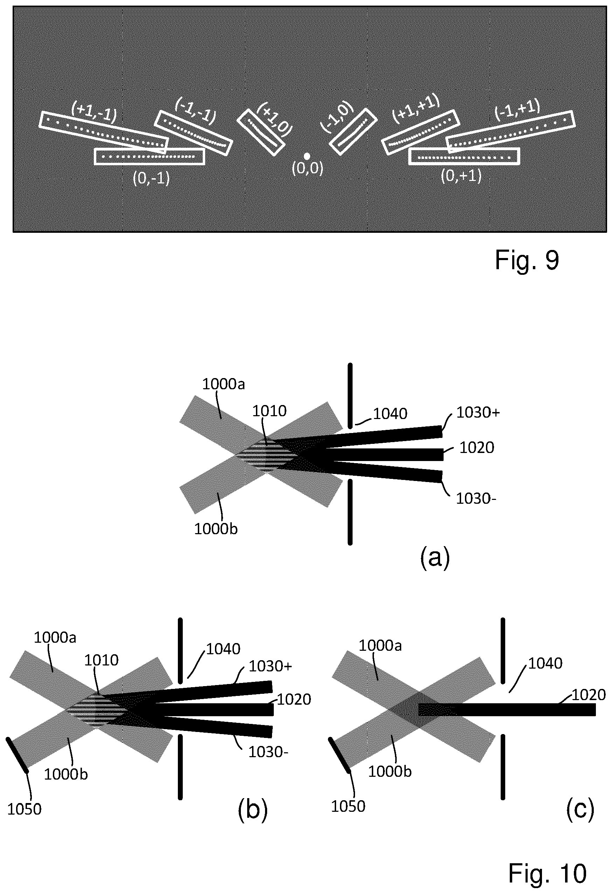

Figure 9 is an example captured image comprising a plurality of captured diffraction orders as labeled, e.g., illustrating where the various orders may be detected on the detector. Note that this example assumes a 1D line grating for the target; the target may also comprise a 2D grating. Each individual dot of a diffraction order may relate to a different wavelength.

The first dispersive element may comprise, for example, a reflective grating or a transmission grating. It may comprise a 1D (line) grating, a 2D grating or a more general dispersive element which creates multiple orders at various diffraction angles. If a grating, the first dispersive element may comprise a varied pitch and/or trench depth, e.g., to correct optical parameters such as wavelength dependent defocus of the wavelength dependent diffraction angle. Also, its orientation can be varied to optimize outgoing diffraction angles.

## Grating at IFP

In its most simple form, the grating at the IFP may comprise a flat, 1D reflective line grating with constant pitch and its lines oriented parallel to the reflection plane (i.e., in a conical diffraction configuration). Both the grating pitch and the angle of incidence can be chosen to optimize the diffraction angles. The angle of incidence may be chosen such that the zeroth order reflection has a large reflection coefficient due to total external reflection (this may comprise a grazing angle of incidence below 20 degrees). The groove profile, and in particular the trench depth of the grating, may be chosen such that the diffraction efficiency in the +1 and -1 orders is maximized or that the combined energy (specular reflection and diffraction efficiencies) of all beams that will be incident on the second dispersive element is maximized. The azimuthal angle between the grating lines and the reflection plane may be zero, but can be made nonzero to optimize the positions of the orders on the detector.

In an embodiment, some of these measurement parameters (e.g., angle of incidence, azimuthal angle, grating pitch) can be varied to optimize the diffracted light for a specific target. For example, in a recipe generation, the configuration may be optimized to create the most favorable angles of incidence on the target for maximum signal divergence/information content. The pitch of the grating can be varied, for example, by providing a line-space grating with variable/selectable pitch or by providing individual gratings arranged to be selectively (individually) switched into the intermediate field plane (e.g., a grating selector or grating wheel comprising multiple gratings of different respective pitches).

Some of these parameter variation examples may be equally applicable to a transmission grating and reflective grating; e.g., azimuthal angle and pitch variation. Typically, higher diffraction efficiencies can be achieved with a transmission grating.

## Grating at SFP

In one embodiment, the first dispersive element is a physical first dispersive element. In one embodiment, the first dispersive element is a virtual first dispersive element. It is also possible to provide the first dispersive element at the SFP, instead of at an IFP, albeit not the physical first dispersive element (i.e., the virtual first dispersive element). At the SFP, the SXR radiation may be generated by focusing a high energy pulsed IR laser (the pump/drive radiation, optionally the pump/drive laser) into a gas jet or gas target. If the local field strength in the gas is sufficiently large, photons, optionally at SXR wavelengths, are generated. Certain source configuration parameters will determine whether all photons emitted in the gas will constructively or destructively interfere in a certain direction, and thus whether the emitted radiation, optionally the SXR radiation, is emitted from the source in a particular direction.

In an embodiment, it is proposed to provide multiple drive laser beams which are configured to overlap (in space and time) in the gas jet. Optionally the multiple drive laser beams are coherent. Due to their coherence, they will interfere and, depending on the angle between the two incoming wavefronts, will generate an interference pattern. For example, an intensity grating may be created in the gas when two beams overlap under an angle. Since SXR photons are only generated above a certain field strength threshold, the SXR source itself is effectively a grating or virtual first dispersive element. As a result, only in specific directions after the gas will the phase of the SXR radiation match, resulting in multiple outgoing beams at various (diffraction) angles. This process has been described, for example, in "Noncollinear enhancement cavity for record-high out-coupling efficiency of an EUV frequency comb" - Zhang et al 2020, which is incorporated herein by reference.

Figure 10(a) illustrates this principle. It schematically shows two infra-red laser pulses 1000a, 1000b which are overlapped to form an intensity grating 1010, resulting in generated SXR radiation comprising a zeroth order 1020 and +1, -1 diffraction orders 1030+, 1030-. A blocking aperture or pinhole 1040 may be provided to block unwanted (e.g., infra-red) radiation.

Figures 10(b) and 10(c) illustrates a variation of this embodiment, where a half-wave plate 1050 has been added to one or both arms of the infra-red laser pulses 1000a, 1000b. By rotating the half-wave plate 1050, the polarization of each arm 1000a, 1000b can be controlled. When both arms have the same polarization, an interference pattern is formed, and SXR is generated at zeroth order 1020 and diffracted order 1030+, 1030- angles (Figure 10(b)). When the polarization is orthogonal, there is no interference and a regular circular intensity pattern is created; thus a single SXR beam 1020 is generated (Figure 10(c)). The half-wave plate 1050 can be rotated to select between the illumination angles and therefore each of the illustrated modes of operation. This effectively provides control to vary the NA of the SXR illumination.

It is also possible to add a delay between IR beams 1000a and 1000b such that the pulses do not interact at all. In that case two completely independent SXR sources are created along the directions of 1000a and 1000b.

It can be appreciated that more than two infra-red drive laser beams may be overlapped in the same manner, enabling more complicated intensity patterns to be generated, e.g., to optimize the diffraction pattern of the outgoing SXR beams. Optionally three infra-red drive laser are overlapped in the same manner. Optionally four infra-red drive laser are overlapped in the same manner.

## Refocusing mirror

Regardless of where the first diffractive element is located, the first scattered radiation (i.e., comprising one or more nonzero diffraction orders) should be captured by the final focusing mirror, which may be the final mirror before the target (or the only mirror for an SFP diffraction embodiment). The captured diffraction angles from the first diffractive element should be reimaged properly, without too many aberrations, e.g., in order to underfill the target grating. The mirror should also have a large capture NA to capture all the wanted diffraction angles.

As such, the final focusing mirror may comprise an ellipsoidal surface. Such a surface ensures (at least nominally) almost aberration free reimaging. While it may be the case that there may be some magnification at some angles of incidence, and therefore non-matching object and image distances, this does not immediately pose a problem while the target is underfilled. In any case, a configuration of the IFP grating and ellipsoid can be chosen to match all magnifications, if desired. To ensure a large NA, the ellipsoidal surface may extend a significant distance.

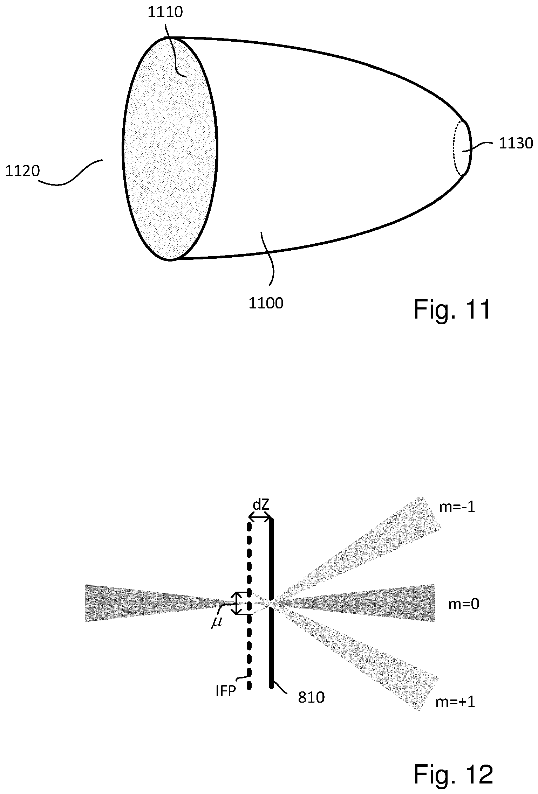

Figure 11 schematically illustrates a proposed focusing mirror element according to an embodiment. The final focusing mirror may comprise an ellipsoidal surface described by an ellipse portion rotated around its major axis. Such a final focusing mirror may therefore comprise a hollow prolate spheroid portion 1100 with a mirrored internal surface 1110. In one embodiment, the hollow prolate spheroid portion may comprise a hollow prolate spheroid portion having a first (input) opening which is larger than the second (output) opening. In another embodiment, the hollow prolate spheroid portion may comprise the hollow prolate spheroid portion having the first (input) opening which is smaller than the second (output) opening. The hollow prolate spheroid portion may, for example, comprise a half-portion or smaller with openings at each end. As such, the final focusing mirror may comprise a hollow prolate spheroid portion with a larger, first opening 1120 at an input end and a smaller, second opening 1130 at an output end. The smaller opening at an output end may be defined by a cut parallel to the minor axis plane near one end of the hollow prolate spheroid. The larger opening at an input end may be defined by a cut along the minor axis plane or a cut parallel to the minor axis plane between the minor axis plane and the output end (e.g., at a point close to the minor axis plane). Such a mirror does not need to be fully rotational symmetric, and may comprise a surface rotated only partially around the major axis. However, such mirrors may be manufactured using an electroforming technique which will result in fully rotationally symmetric mirror. This also provides additional mechanical stability.

A proposed method for manufacturing such a mirror may be based on the disclosure of WO2019/238382, incorporated herein by reference. The configuration of the actual mirror described therein is quite different to that proposed herein, but the basic concept of the manufacturing method described therein can be used to manufacture the proposed final focusing mirror.

The proposed method may therefore comprise a method of manufacturing a focusing mirror element comprising: providing an axially symmetric mandrel comprising a prolate spheroid portion; forming a focusing mirror element body around the mandrel; and releasing the focusing mirror element body from the mandrel whereby the focusing mirror element body has an optical surface defined by the internal surface of the focusing mirror element body. The mandrel may comprise a super polished surface, e.g., resultant from a super polishing step using a process selected from the group consisting of: Magneto-Rheological Fluid Finishing (MRF), Fluid Jet Polishing (FJP), Elastic Emission Machining (EEM), Ion Beam Figuring and Float Polishing. Such a super polishing step may be performed so that the mandrel surface has a surface roughness less than 100 pm Root Mean Square (RMS) optionally, less than 50 pm (RMS), optionally less than 35 pm RMS. Alternatively or in addition, a reflection enhancing single or multi-layer coating may be applied to the optical surface of the focusing mirror element body. Alternatively or in addition, an electrode and release layer may be applied to the mandrel before the forming step.

It may be appreciated that ellipsoids are quite sensitive to misalignment, and that sensitivity quickly increases for increasing beam divergence. However, the proposed manner of using the final focusing mirror and ellipsoidal surface proposed herein do not result in a larger beam divergence, but instead results in a plurality of beams with a small divergence over a large angular spread. Sensitivities of the individual low divergent beams may still be small.

**Phase Detection**

In another embodiment, it is proposed to use the same basic concepts as described above to modify the illumination configuration to enable direct phase detection. The proposed direct phase detection may be in a manner akin to shearing interferometry. In shearing interferometry, the phase of a (probe) radiation beam is probed by (partially) overlapping the beam with a reference beam that is coherent with the probe beam. The wavefronts of both beams are tilted with respect to each other, causing an interference pattern with fringes to be formed.

To create two mutually coherent beams, the SXR radiation from the source may be initially focused at an intermediate focus. A diffractive element (e.g., the first diffractive element or grating described previously) may be located at this intermediate focus. The first dispersive element or intermediate focus grating can be oriented in a conical orientation (lines parallel to the plane of reflection) or a planar orientation (lines perpendicular to the plane of reflection). In other embodiments the lines can also be oblique (e.g., not exactly parallel or not exactly perpendicular) with respect to the plane of reflection, but oriented under a certain azimuthal angle. As before, the first diffractive element may comprise a reflective element (e.g., reflective grating) or a transmissive element (e.g., transmissive grating). In the further description, it will be assumed that the orientation of first dispersive element is purely conical. As with the previous embodiment, the first dispersive element will generate first scattered radiation comprising a number of beams: diffraction orders ($\pm m, \lambda$,) with $m$ the order of the diffraction peaks and $\lambda$ the wavelength, as the grating disperses the radiation in various angles. The special case of m=0 may be recognized as the specularly reflected or zeroth order beam. The beams m=0, m=-1,$\lambda$, and m=+1,$\lambda$ (and higher orders if the configuration allows) are collected by an ellipsoidal mirror or final focusing mirror (e.g., as has been described), which refocuses the beams on the second diffractive element or target that is under inspection.

It will be assumed for now that the orientation of second dispersive element is also conical. The beams incident on second dispersive element will again diffract to diffraction orders ($\pm n, \lambda$,) and, for simplicity, only the zeroth and first diffraction orders of incident beams m= -1 and m=+1 will be discussed below (the wavelength argument is also left out for notational simplicity, where it is implicitly assumed that the beams are monochromatic at a certain wavelength in the spectrum; a wavelength dependent formalism is also presented further below). The diffracted beams from second dispersive element can thus be categorized as follows: (m,n) = (-1,-1), (m,n) = (-1,0), (m,n) = (-1,+1), (m,n) = (+1,-1), (m,n) = (+1,0), (m,n) = (+1,+1).

It can be demonstrated that there are configuration parameters for which some of these beams will spatially overlap on the detector, such that they interfere. Two logical combinations are to use the zeroth order reflection from second dispersive element as the reference beam and an appropriate first order diffraction beam as the probe beam: e.g., a beam pair may comprise using (m,n)=(-1,0) as the reference beam and (m,n)=(+1,-1) as the probe beam or (m,n)=(+1,0) as the reference beam and (m,n)=(-1,+1) as the probe beam. Both of these beam pairs are illustrated as overlapping in Figure 8(b). These are only examples and other combinations may be made to overlap also.

To create a (fringed) interference pattern using an overlapping beam pair, their wavefronts need to be mutually tilted with respect to each other. This can be realized by providing mutually (slightly) displaced points of origin for the two beams, such that each beam of a beam pair has a slightly different point of origin.

While there is not much space to accommodate such displaced points of origin as the target is typically very small, the required tilt (and therefore the displacement) is also very small. For example, the optical path-length difference (OPD) in terms of waves, as a function of angle $\alpha$ within the beam divergence may be determined as:

$$\text{OPD} = \frac{\mu \alpha}{\lambda} \cos \theta$$

where $\mu$ be the point of origin displacement on the target and $\theta$ is the obliquity angle of the outgoing beams with the target surface normal.

Assuming, for example, that the $1/e^2$ divergence of the beam is about 2 mrad and that at least two fringes over the full angle beam divergence at $\theta = 0$ are required, then the required displacement would be $\mu$ = 6.8 $\mu$m (assuming $\lambda$ = 13.5 nm). Thus, the foci of the beam m= -1 and beam m=+1 on the target should be laterally displaced by at least 6.8 $\mu$m, or more generally more than 4$\mu$m, more than 5$\mu$m or more than 6$\mu$m (e.g., between 4$\mu$m and 10$\mu$m, between 5$\mu$m and 10$\mu$m, between 5$\mu$m and 9$\mu$m, between 5.5$\mu$m and 9$\mu$m, between 6$\mu$m and 9$\mu$m, between 6$\mu$m and 8$\mu$m, between 6$\mu$m and 7$\mu$m or between 6.5$\mu$m and 7$\mu$m).

To achieve this, it is proposed that the beam m=-1 is provided with a first tilt in the illumination pupil and the beam m=+1 is provided with a second tilt in the illumination pupil. The illumination pupil may comprise a pupil plane or Fourier plane in the illumination branch before the target/second diffractive element. In an embodiment, the first tilt and second tilt may be equal in magnitude and opposite in direction. This corresponds to an even aberration over the whole illumination pupil.

Figure 12 schematically illustrates an example (part) configuration for achieving this. The simplest even aberration is a defocus and the simplest way to insert a defocus in the configuration is by locating the first dispersive element slightly out of focus (e.g., slightly displaced from the intermediate field plane, i.e., a conjugate plane of the target and source). As such, the first dispersive element 810 is located at a defocus dZ displacement away from the intermediate field plane IFP. By placing the first dispersive element 810 slightly out of focus, the apparent foci of the orders are displaced $\mu$ with respect to each other. The final focusing mirror images the conjugate plane of the source as before.

The required defocus dZ may be calculated as:

$$dZ = \frac{1}{2} \mu \sqrt{\frac{p_1^2 \sin^2 \theta_{G1}}{\lambda^2} - 1}$$

where $\theta_{G1}$ is the angle of incidence on the first dispersive element and p1 the pitch of first dispersive element.

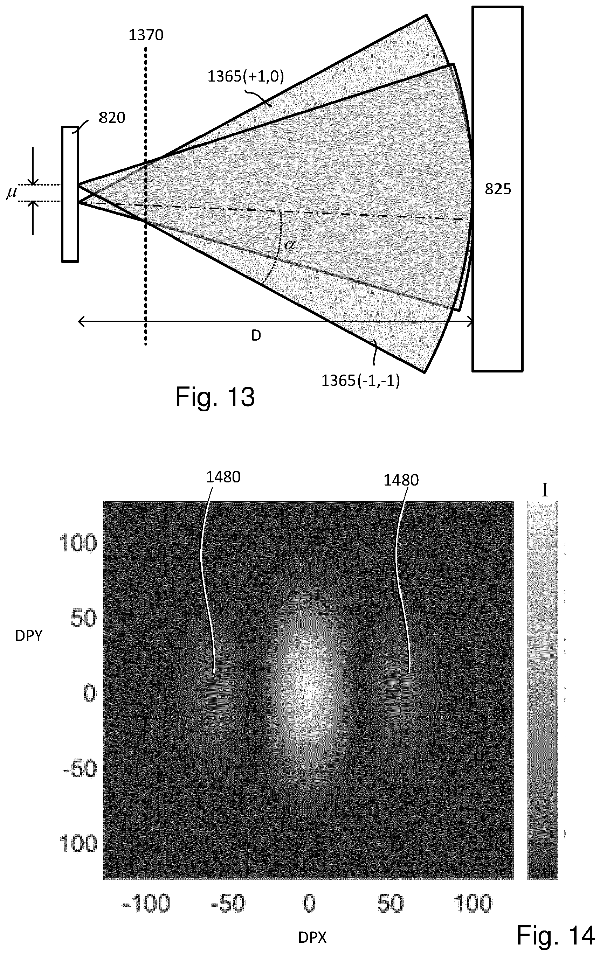

Figure 13 is a schematic drawing illustrating how a nonzero value of $\mu$ results in the (spherical) wavefronts 1365(+1,0), 1365(-1,-1), relating to the (+1,0) and (-1,-1) diffraction orders respectively, being slightly tilted with respect to each other; this in turn results in an (angle $\alpha$ dependent) OPD. Plane 1370 is the conjugate plane of the first diffractive element.

Figure 14 shows an example (simulated) fringe pattern as might be seen on the detector (single color) when performing the method of this embodiment. The Figure shows an intensity I plot (with brighter regions indicating higher intensity) of X detector pixel position DPX against Y detector pixel position DPY. The (left/right) position of the fringes 1480 will depend on the phase difference between e.g., the beams (m,n)=(-1,0) and (m,n)=(+1,-1); this is the phase information which provides additional information on the target. As such, the phase difference between the beams can be determined from the position of fringes on the detector.

This phase difference can be used to infer one or more target parameters. For example, swing curves describing the phase difference as a function of wavelength can be determined and used to infer the one or more target parameters. Such swing curves can be shown to vary significantly for variation in some target parameters (e.g., CD and grating height).

**Detailed formalism**

So far it was assumed that the reference and probe beams can be made to overlap on the detector. Below is the formalism describing under what conditions this is indeed the case. Starting with the conical grating equation:

$$\begin{pmatrix} \sin\theta_f \cos\varphi_f \\ \sin\theta_f \sin\varphi_f \\ \cos\theta_f \end{pmatrix} - \begin{pmatrix} \sin\theta_i \cos\varphi_i \\ \sin\theta_i \sin\varphi_i \\ -\cos\theta_i \end{pmatrix} = \begin{pmatrix} h\lambda/p_x \\ k\lambda/p_y \\ l\lambda \end{pmatrix}$$

where $\theta_i$ and $\theta_f$ are respectively the incoming and outgoing inclination angles, $\varphi_i$ and $\varphi_f$ are respectively the incoming and outgoing azimuthal angles, $p_x$ and $p_y$ the grating pitches respectively in x and y directions and (h,k,l) the reciprocal lattice coordinates. The Z-component can be ignored as that is mainly balancing energy conservation. Moreover, in conical diffraction h=0 and k=m as defined above.

To simplify notation, the equation for grating j in conical configuration will be denoted as:

$$q_f^j(\theta_{f,j}, \varphi_{f,j}) = q_i^j(\theta_{i,j}, \varphi_{i,j}) + K_m^j(p_{y,j})$$

with $q_i^j$ the incoming beam, $q_f^j$ the outgoing beam and $K_m^j$ the grating vector.

After the first grating, the outgoing beam is reimaged and incident on the second grating under a different angle. Let $\theta_j$ be the zeroth order inclination angle on grating *j* and $\Delta\theta = \theta_2 - \theta_1$ be the difference in inclination angle between first dispersive element and second dispersive element; then the outgoing beams after second dispersive element can be written as the combination of the two equations:

$$q_f^1(\theta_{f,1}, \varphi_{f,1}) = q_i^1(\theta_1, \varphi_{i,1}) + K_m^1(p_{y,1})$$

$$q_f^2(\theta_{f,2}, \varphi_{f,2}) = q_f^1(\theta_{f,1} + \Delta\theta, \varphi_{f,1}) + K_n^2(p_{y,2})$$

When $\Delta\theta = 0$ the equation becomes much simpler:

$$q_f^2(\theta_{f,2}, \varphi_{f,2}) = q_i^1(\theta_1, \varphi_{i,1}) + K_m^1(p_{y,1}) + K_n^2(p_{y,2})$$

where $q_i^2$ is simply equated to $q_f^1$ and the condition for beams to overlap is written as:

$$K_m^1 + K_n^2 = K_{m'}^1 + K_{n'}^2$$

which is equal to:

$$\frac{m}{\epsilon p} + \frac{n}{p} = \frac{m'}{\epsilon p} + \frac{n'}{p}$$

where $\varepsilon$ is the ratio between the pitch on first dispersive element and the pitch on second dispersive element and $p$ the pitch of the second dispersive element (e.g., the target). For $\varepsilon = 2$ the above condition is fulfilled for the combinations (m,n)=(-1,0) and (m',n')=(+1,-1) and the combination (m,n)=(+1,0) and (m',n')=(-1,+1). Note that the wavelength dependence has dropped out, and beam matching is thus achieved for all wavelengths in the spectrum at the same time.

The treatment above assumes that the angle of incidence on the first dispersive element is equal to the angle of incidence on the second dispersive element. While this is not *a priori* a problem, this would mean significant transmission losses on the first dispersive element for, for example, an angle of incidence of $\theta_2$ = 30° on a target. One alternative is to have a more grazing angle of incidence on both of the first dispersive element and second dispersive element. Until now, this was not considered because (1) for small target pitches the orders no longer propagate; and (2) it becomes more difficult to underfill a target due to the projection of the focus on the wafer plane. Nonetheless, embodiments may be envisaged where such an 'equal angle of incidence' geometry is applied, for example when using a range of shorter wavelengths or designing a first dispersive element grating that has sufficient diffraction efficiency at larger angles of incidence by e.g., applying broadband (multilayer) coatings. Also, such an equal angle of incidence geometry may suit some applications (e.g. because mostly larger pitches are of interest).

In another embodiment, a more grazing angle of incidence is chosen on first dispersive element to maintain high diffraction efficiency and reflectivity with a simple coating while maintaining a close to normal angle of incidence on the target. In such an arrangement, $\Delta\theta$ will be nonzero in the above equations. Since $q_i^2$ can no longer be equated to $q_f^1$, then $\theta_{f,1}$ should be evaluated explicitly in terms of the incoming beam coordinates:

$$\sin^2 \theta_{f,1} = \sin^2 \theta_1 + (K_m^1)^2$$

With this expression it is possible to evaluate $q_f^2$, to obtain a similar condition as above (to first order approximation in $K_m^1$):

$$\frac{m}{\epsilon p} + \frac{n}{p} + \sin\Delta\theta \cos\left\{\sin^{-1}\left[\left(1 + \left(\frac{K_m^1}{\sin\theta_1}\right)^2\right)\sin\theta_1\right]\right\} = const$$

Since this expression now comprises $K_m^1$, there is a wavelength dependence in the direction of the outgoing beams present. Moreover, the pitch of the first grating is no longer a simple multiple of the target pitch. The wavelength dependence is not an immediate problem as long as the difference in outgoing beam directions of the two beams that are supposed to overlap is small relative to the divergence of the beams. Also, there a pitch p1 can always be found such that the overlap is perfect for at least one wavelength. A recurrence relation for finding the best matching pitch $p_1$ given angles of incidence $\theta_1$ and $\theta_2$ on first dispersive element and second dispersive element and target pitch $p_2$ of second dispersive element for single wavelength is given by:

$$p_1 = 2p_2 \sin\left(\sin^{-1}\left(\sqrt{\sin^2\theta_1 + \left(\frac{\lambda}{p_1}\right)^2}\right) + \theta_2 - \theta_1\right) \bigg/ \sqrt{\sin^2\theta_1 + \left(\frac{\lambda}{p_1}\right)^2}$$

For this pitch, the overlap at wavelength $\lambda$ is perfect, with decreasing overlap for wavelengths further away.

## Additional embodiments

There are a number of parameters in addition to those mentioned above that could be tuned in order to optimize beam overlap. For example, in an embodiment, one or both of the first azimuthal angle of incidence on the first dispersive element and the second azimuthal angle of incidence on the second dispersive element may be tuned. The pitch of the first dispersive element may be variable (e.g., a variable line space grating) to provide a wavelength dependent defocus and tilt aberration. The first dispersive element may comprise a transmission grating or a more complex diffractive element. The optical parameters of the ellipsoidal final focusing mirror between first dispersive element and second dispersive element (e.g. angle of incidence, image distance, object distance) may be optimized, e.g., to have all orders reflect at the symmetry plane intersecting the long ellipsoidal axis. As already stated, different beam pairs to those explicitly described could be made to overlap.

The pitch of the first dispersive element $p_1$ is linked to the target pitch $p_2$. For small target pitch variations (e.g., pitch walk) the angle of incidence on first dispersive element may be modified to retrieve the overlap condition according to the recurrence relation above. For larger changes to the target pitch, a different first dispersive element pitch is required. In an embodiment this can be implemented by providing a grating selector or grating wheel as has already been described.

In an embodiment, various exposure schemes may be used. For example, by subsequently 1) exposing the target with both m= -1 and m=+1 beams simultaneously (obtaining interference fringes as a result) and 2) exposing with the m=-1 and m=+1 beams sequentially. The resultant data may be analyzed by determining a difference of these exposures, thereby obtaining only the phase response and a much cleaner signal due to the scatter and non-interfering radiation being removed.

In an embodiment, color selection could be achieved by blocking some of the wavelengths in the diffraction orders m after first dispersive element. In most of the text above only $m \neq 0$ orders were considered, but the m=0 beam from first dispersive element can still be used for conventional SXR metrology or (m,n)=(0,+/-n) beams can be made to interfere with m $\neq$ 0 beams.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:

1. A metrology tool comprising:

a first dispersive element operable to receive and scatter source radiation so as to generate first scattered radiation;
a final focusing element being configured to:

collect at least a portion of said first scattered radiation, the collected first scattered radiation comprising a plurality of first scattered beams, each having been scattered in a respective different direction; and

focus said collected first scattered radiation on a second dispersive element such that each of said first scattered beams is incident on said second dispersive element at a respective different angle of incidence; and

at least one detector operable to detect second scattered radiation having been scattered by said second dispersive element.

2. A metrology tool as claimed in clause 1, wherein said first dispersive element comprises a grating.

3. A metrology tool as claimed in clause 1 or 2, comprising a first focusing element being operable to focus said source radiation at an intermediate field plane.

4. A metrology tool as claimed in clause 3, wherein said first focusing element comprises a first focusing mirror element.

5. A metrology tool as claimed in any of clauses 2 to 4, wherein said first dispersive element is located at said intermediate field plane.

6. A metrology tool as claimed in clause 3 or 4, wherein said metrology tool is configured such that: at least one pair of second scattered beams comprised within the second scattered radiation overlap on the detector to form interference fringes.

7. A metrology tool as claimed in clause 6, wherein said metrology tool is configured to determine a phase difference between the beams of each pair of second scattered beams from the position of respective said interference fringes on the detector for each said pair of second scattered beams.

8. A metrology tool as claimed in clause 6 or 7, configured such that at least one pair of said first scattered beams comprises respective different effective points of origin in said intermediate field plane.

9. A metrology tool as claimed in clause 8, wherein the displacement between the respective different effective points of origin is more than $4\mu$m.

10. A metrology tool as claimed in clause 8, wherein the displacement between the respective different effective points of origin is between $4\mu$m and $10\mu$m.

11. A metrology tool as claimed in clause 8, wherein the displacement between the respective different effective points of origin is between $5\mu$m and $9\mu$m.

12. A metrology tool as claimed in any of clauses 6 to 11, wherein said first dispersive element is located at a defocus distance from said intermediate field plane.

13. A metrology tool as claimed in clause 1, wherein said first dispersive element comprises a virtual first dispersive element located at a source plane.

14. A metrology tool as claimed in clause 13, comprising a radiation source for generating the source radiation, the radiation source comprising a laser source arrangement operable to generate a pair of radiation beams towards a gas target such that the pair of radiation beams overlap temporally and spatially and at respective different angles in the gas target so as to generate an interference pattern forming said virtual first dispersive element.

15. A metrology tool as claimed in clause 14, comprising a rotatable waveplate in the path of at least one radiation beam of said pair of radiation beams.

16. A metrology tool as claimed in clause 14 or 15, wherein said radiation source is operable to generate source radiation comprising one or more wavelengths in the range 1nm to 20nm.

17. A metrology tool as claimed in any of clauses 1 to 12, further comprising a radiation source for generating the source radiation, wherein said radiation source is operable to generate source radiation comprising one or more wavelengths in the range 1nm to 20nm.

18. A metrology tool as claimed in any preceding clause, wherein said final focusing element comprises a final focusing mirror element.

19. A metrology tool as claimed in clause 18, wherein said final focusing mirror element comprises a hollow prolate spheroid portion, having a reflective internal surface.

20. A metrology tool as claimed in clause 19, wherein said hollow prolate spheroid portion comprises a first opening at an input end and a second opening at an output end.

21. A metrology tool as claimed in clause 19, wherein the first opening and second opening are each defined by a cut parallel to the minor axis plane of the hollow prolate spheroid.

22. A metrology tool as claimed in clause 20 or 21, wherein the first opening is larger than the second opening.

23. A metrology tool as claimed in clause 23, wherein the first opening is defined by a cut along the minor axis plane or a cut parallel to the minor axis plane between the minor axis plane and the output end.

24. A metrology tool as claimed in any preceding clause, wherein said final focusing element is fully rotational symmetric.

25. A metrology tool as claimed in any preceding clause, wherein said second dispersive element comprises a target being measured.

26. A metrology tool as claimed in any preceding clause, comprising determining a value for at least one parameter of interest relating to said second dispersive element from the second scattered radiation.

27. A focusing mirror element comprising a hollow prolate spheroid portion, having a reflective internal surface and comprising a first opening at an input end and a second opening at an output end.

28. A focusing mirror element as claimed in clause 27, wherein the first opening and second opening are each defined by a cut parallel to the minor axis plane of the hollow prolate spheroid.

29. A focusing mirror element as claimed in clause 26, wherein the first opening is larger than the second opening.

30. A focusing mirror element as claimed in clause 29, wherein the first opening is defined by a cut along the minor axis plane or a cut parallel to the minor axis plane between the minor axis plane and the output end.

31. A focusing mirror element as claimed in any of clauses 27 to 30, wherein said focusing element is fully rotational symmetric.

32. A method of manufacturing the focusing mirror element of any of clauses 27 to 31, comprising

providing an axially symmetric mandrel comprising a prolate spheroid portion;
forming a focusing mirror element body around the mandrel; and
releasing the focusing mirror element body from the mandrel;
whereby the focusing mirror element body has an optical surface defined by the internal surface of the focusing mirror element body.

33. A method as claimed in clause 32, comprising performing a super polishing step on said mandrel using a process selected from the group consisting of: Magneto- Rheological Fluid Finishing (MRF), Fluid Jet Polishing (FJP), Elastic Emission Machining (EEM), Ion Beam Figuring and Float Polishing.

34. A method as claimed in clause 33, wherein said super polishing step is performed so that the mandrel surface has a surface roughness less than 200 pm Root Mean Square (RMS), optionally, less than 100 pm (RMS) optionally, less than 50 pm (RMS), optionally less than 35 pm RMS.

35. A method as claimed in any of clauses 32 to 34, comprising applying a reflection enhancing single or multi-layer coating to the mirrored surface of the focusing mirror element body.

36. A method as claimed in any of clauses 32 to 35, comprising applying an electrode and release layer to the mandrel before the forming step.

37. A metrology method comprising:

generating source radiation;
scattering the source radiation so as to generate first scattered radiation;
collecting at least a portion of said first scattered radiation, the collected first scattered radiation comprising a plurality of first scattered beams, each having been scattered in a respective different direction;
focusing said collected first scattered radiation on a target such that each of said first scattered beams is incident on said target at a respective different angle of incidence; and
detecting second scattered radiation having been scattered by said target.

38. A metrology method as claimed in clause 37, comprising focusing said source radiation at an intermediate field plane.

39. A metrology method as claimed in clause 38, wherein said source radiation is scattered at said intermediate field plane.

40. A metrology method as claimed in clause 38, comprising overlapping at least one pair of second scattered beams comprised within the second scattered radiation at a detector to form interference fringes on the detector.

41. A metrology method as claimed in clause 40, comprising determining a phase difference between the beams of each pair of second scattered beams from the position of respective said interference fringes on the detector for each said pair of second scattered beams.

42. A metrology method as claimed in clause 38 or 41, wherein at least one pair of said first scattered beams comprises respective different effective points of origin in said intermediate field plane.

43. A metrology method as claimed in clause 42, wherein the displacement between the respective different effective points of origin is more than $4\mu$m.

44. A metrology method as claimed in clause 42, wherein the displacement between the respective different effective points of origin is between $4\mu$m and $10\mu$m.

45. A metrology method as claimed in clause 42, wherein the displacement between the respective different effective points of origin is between $5\mu$m and $9\mu$m.

46. A metrology method as claimed in any of clauses 40 to 45, comprising focusing said source radiation at a defocus distance from said intermediate field plane.

47. A metrology method as claimed in clause 37, comprising generating a virtual first dispersive element at a source plane.

48. A metrology method as claimed in clause 47, comprising generating a pair of radiation beams and directing them at a gas target such that the pair of radiation beams overlap temporally and spatially and at respective different angles in the gas target so as to generate an interference pattern forming said virtual first dispersive element.

49. A metrology method as claimed in clause 48, comprising controlling the polarization of at least one radiation beam of said pair of radiation beams.

50. A metrology method as claimed in any of clauses 37 to 49, wherein said source radiation comprises one or more wavelengths in the range 1nm to 20nm.

51. A metrology method as claimed in any preceding clause, wherein said collecting step and said focusing said collected first scattered radiation on a target step are performed using a focusing mirror element of any of clauses 27 to 31.

52. A metrology method as claimed in any of clauses 37 to 51, comprising determining a value for at least one parameter of interest relating to said target from the second scattered radiation.

53. A metrology method as claimed in any of clauses 37 to 52, comprising optimizing one or more measurement parameters to optimize said first scattered radiation for said target.

54. A method comprising:

generating a source radiation, wherein the source radiation comprise SXR;
scattering the source radiation so as to generate a plurality of first scattered beams;
exposing a substrate to the plurality of first scattered beams such that each of the first scattered beams is incident on the substrate at a respective different angle of incidence, to generate a second scattered radiation;
detecting the second scattered radiation; and
determining a parameter of interest using the detected second scattered radiation.

54. An apparatus with SXR source configured to measure a parameter of interest during manufacturing process at multiple angles of incidence simultaneously.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays, and with other radiations, including electron beam radiations and (charged) particle radiations.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

**Claims**

**1.** A metrology tool comprising:

a first dispersive element operable to receive and scatter a source radiation so as to generate a first scattered radiation;
a final focusing element being configured to:

collect at least a portion of said first scattered radiation, the collected first scattered radiation comprising a plurality of first scattered beams, each having been scattered in a respective different direction; and
focus said collected first scattered radiation on a second dispersive element such that each of said first scattered beams is incident on said second dispersive element at a respective different angle of incidence; and

at least one detector operable to detect a second scattered radiation having been scattered by said second dispersive element.

**2.** A metrology tool as claimed in claim 1, comprising a first focusing element being operable to focus said source radiation at an intermediate field plane.

**3.** A metrology tool as claimed in claim 2, wherein said first dispersive element is located at said intermediate field plane.

**4.** A metrology tool as claimed in any of the preceding claims, wherein said metrology tool is configured such that:
at least one pair of second scattered beams comprised within the second scattered radiation overlap on the detector to form interference fringes.

**5.** A metrology tool as claimed in claim 4, wherein said metrology tool is configured to determine a phase difference between the beams of each pair of second scattered beams from the position of respective said interference fringes on the detector for each said pair of second scattered beams.

**6.** A metrology tool as claimed in any of claims 2 to 5, configured such that at least one pair of said first scattered beams comprises respective different effective points of origin in said intermediate field plane.

**7.** A metrology tool as claimed in claim 6, wherein the displacement between the respective different effective points of origin is more than $4\mu$m.

**8.** A metrology tool as claimed in any of claims 2 to 7, wherein said first dispersive element is located at a defocus distance from said intermediate field plane.

9. A metrology tool as claimed in claim 1, wherein said first dispersive element comprises a virtual first dispersive element located at a source plane.

10. A metrology tool as claimed in claim 9, comprising a radiation source for generating the source radiation, the radiation source comprising a laser source arrangement operable to generate a pair of radiation beams towards a gas target such that the pair of radiation beams overlap temporally and spatially and at respective different angles in the gas target so as to generate an interference pattern forming said virtual first dispersive element.

11. A metrology tool as claimed in claim 10, comprising a rotatable waveplate in the path of at least one radiation beam of said pair of radiation beams.

12. A metrology tool as claimed in any preceding claim, wherein said final focusing element comprises a final focusing mirror element, and wherein said final focusing mirror element comprises a hollow prolate spheroid portion, having a reflective internal surface.

13. A metrology tool as claimed in any preceding claim, wherein said second dispersive element comprises a target being measured.

14. A method comprising:

generating a source radiation, wherein the source radiation comprise SXR;
scattering the source radiation so as to generate a plurality of first scattered beams;
exposing a substrate to the plurality of first scattered beams such that each of the first scattered beams is incident on the substrate at a respective different angle of incidence, to generate a second scattered radiation;
detecting the second scattered radiation; and
determining a parameter of interest using the detected second scattered radiation.

15. An apparatus with SXR source configured to measure a parameter of interest during manufacturing process at multiple angles of incidence simultaneously.

Fig. 1

Fig. 2

LA

SC1

SC3

CL

-1    0    +1

MT

SC2

Fig. 3

2

4

SM1

Z

X

PU

W

6

I

λ

8

Z

X

Fig. 4

Fig. 5

Fig. 6

Fig. 7

(a)

(b)

Fig. 8

Fig. 9

Fig. 10

Fig. 11

Fig. 12

Fig. 13

Fig. 14

EP 4 414 785 A1

Europäisches
Patentamt

European
Patent Office

Office européen
des brevets

# EUROPEAN SEARCH REPORT

Application Number

EP 23 15 6294

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | WO 2023/001448 A1 (ASML NETHERLANDS BV [NL]) 26 January 2023 (2023-01-26)<br>* paragraph [0011] *<br>* paragraph [0021] - paragraph [0022] *<br>* paragraph [0027] *<br>* paragraph [0034] *<br>* paragraph [0036] *<br>* paragraph [0046] *<br>* paragraph [0062] - paragraph [0071] *<br>* paragraph [0093] *<br>* figure 6(a) * | 1-3,<br>13-15<br>12 | INV.<br>G03F7/00 |
| Y<br>A | WO 2013/180885 A1 (CYMER LLC [US]) 5 December 2013 (2013-12-05)<br>* paragraph [003] *<br>* paragraph [0027] *<br>* figure 1 * | 12<br>14,15 | |
| A | GB 626 384 A (JOHN HENRY JEFFREE; COMBINED OPTICAL IND LTD) 14 July 1949 (1949-07-14)<br>* page 4, lines 27-32 *<br>* page 4, lines 41-43 * | 12 | TECHNICAL FIELDS SEARCHED (IPC) |
| X<br>Y | WO 2017/092957 A1 (ASML NETHERLANDS BV [NL]) 8 June 2017 (2017-06-08)<br>* paragraph [0064] - paragraph [0093] *<br>* paragraph [00120] - paragraph [00131] *<br>* paragraph [00137] - paragraph [00140] *<br>* paragraph [00146] *<br>* paragraph [00149] - paragraph [00155] *<br>* paragraph [00169] *<br>* paragraph [00172] - paragraph [00173] *<br>* figures 1-9, 15-20, 24-25 * | 1-3,<br>13-15<br>12 | G03F<br>G01B<br>G01N |

-/--

The present search report has been drawn up for all claims

| Place of search | Date of completion of the search | Examiner |
|---|---|---|
| Munich | 12 July 2023 | Maslankiewicz, Pawel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

## EUROPEAN SEARCH REPORT

Europäisches
Patentamt
European
Patent Office
Office européen
des brevets

Application Number

EP 23 15 6294

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 596 413 A (STANTON STUART [US] ET AL) 21 January 1997 (1997-01-21)<br>* column 4, lines 13-15 *<br>* column 5, line 41 - column 7, line 23 *<br>* column 10, lines 22-23 *<br>* figures 1-2 * | 1-3,13 | |
| X | EP 3 719 545 A1 (ASML NETHERLANDS BV [NL]) 7 October 2020 (2020-10-07)<br>* paragraph [0041] - paragraph [0092] *<br>* figures 2-13 * | 14,15 | |
| X | WO 2018/050350 A1 (ASML NETHERLANDS BV [NL]) 22 March 2018 (2018-03-22)<br>* paragraph [0045] - paragraph [0046] *<br>* paragraph [0055] - paragraph [0066] *<br>* figure 5 * | 15 | |
| T | ZHANG C ET AL: "Noncollinear enhancement cavity for record-high out-coupling efficiency of an extreme-UV frequency comb",<br>ARXIV.ORG, CORNELL UNIVERSITY LIBRARY, 201 OLIN LIBRARY, CORNELL UNIVERSITY ITHACA, NY 14853, USA,<br>5 March 2020 (2020-03-05), XP081752636,<br>DOI: 10.1103/PHYSREVLETT.125.093902<br>* page 2, third paragraph - page 3, first paragraph;<br>figure 1 *<br>* "Supplemental material", item 1, first paragraph * | | TECHNICAL FIELDS SEARCHED (IPC) |

The present search report has been drawn up for all claims

| Place of search | Date of completion of the search | Examiner |
|---|---|---|
| Munich | 12 July 2023 | Maslankiewicz, Pawel |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons
..................................................................
& : member of the same patent family, corresponding
   document

EPO FORM 1503 03.82 (P04C01)

Europäisches
Patentamt

European
Patent Office

Office européen
des brevets

**Application Number**

**EP 23 15 6294**

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-3, 14, 15(completely); 12, 13(partially)

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 23 15 6294

The Search Division considers that the present European patent application does not comply with the requirements of unity of invention and relates to several inventions or groups of inventions, namely:

1. claims: 1-3, 14, 15(completely); 12, 13(partially)

   Metrology based on multiple angles of incidence of a plurality of diffraction beams formed at a physical dispersive element located at a focus of source radiation
   ---

2. claims: 4-8(completely); 12, 13(partially)

   Metrology based on shearing interferometry
   ---

3. claims: 9-11(completely); 12, 13(partially)

   Metrology using a plurality of incident beams generated at a gas source by two crossing laser beams forming a virtual grating
   ---

**EP 4 414 785 A1**

## ANNEX TO THE EUROPEAN SEARCH REPORT
## ON EUROPEAN PATENT APPLICATION NO.

EP 23 15 6294

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2023

| Patent document cited in search report | | Publication date | Patent family member(s) | | Publication date |
|---|---|---|---|---|---|
| WO 2023001448 | A1 | 26-01-2023 | TW | 202309671 A | 01-03-2023 |
| | | | WO | 2023001448 A1 | 26-01-2023 |
| WO 2013180885 | A1 | 05-12-2013 | JP | 6843038 B2 | 17-03-2021 |
| | | | JP | 2015525474 A | 03-09-2015 |
| | | | JP | 2018046304 A | 22-03-2018 |
| | | | KR | 20150016576 A | 12-02-2015 |
| | | | TW | 201352072 A | 16-12-2013 |
| | | | US | 2013322482 A1 | 05-12-2013 |
| | | | WO | 2013180885 A1 | 05-12-2013 |
| GB 626384 | A | 14-07-1949 | NONE | | |
| WO 2017092957 | A1 | 08-06-2017 | JP | 6654251 B2 | 26-02-2020 |
| | | | JP | 2018536907 A | 13-12-2018 |
| | | | NL | 2017710 A | 07-06-2017 |
| | | | US | 2018348647 A1 | 06-12-2018 |
| | | | US | 2020004163 A1 | 02-01-2020 |
| | | | WO | 2017092957 A1 | 08-06-2017 |
| US 5596413 | A | 21-01-1997 | NONE | | |
| EP 3719545 | A1 | 07-10-2020 | CN | 113711090 A | 26-11-2021 |
| | | | EP | 3719545 A1 | 07-10-2020 |
| | | | EP | 3948369 A1 | 09-02-2022 |
| | | | IL | 286329 A | 31-10-2021 |
| | | | JP | 7353380 B2 | 29-09-2023 |
| | | | JP | 2022526231 A | 24-05-2022 |
| | | | KR | 20210134962 A | 11-11-2021 |
| | | | TW | 202043906 A | 01-12-2020 |
| | | | US | 2022221629 A1 | 14-07-2022 |
| | | | WO | 2020200646 A1 | 08-10-2020 |
| WO 2018050350 | A1 | 22-03-2018 | CN | 109716110 A | 03-05-2019 |
| | | | EP | 3296723 A1 | 21-03-2018 |
| | | | IL | 265282 A | 30-05-2019 |
| | | | JP | 6959339 B2 | 02-11-2021 |
| | | | JP | 7271628 B2 | 11-05-2023 |
| | | | JP | 2019529953 A | 17-10-2019 |
| | | | JP | 2022019719 A | 27-01-2022 |
| | | | KR | 20190051029 A | 14-05-2019 |
| | | | KR | 20210061474 A | 27-05-2021 |
| | | | TW | 201823713 A | 01-07-2018 |
| | | | TW | 201930861 A | 01-08-2019 |
| | | | US | 2018073992 A1 | 15-03-2018 |
| | | | US | 2019003981 A1 | 03-01-2019 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 23 15 6294

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2023

| Patent document cited in search report | Publication date | Patent family member(s) | | Publication date |
|---|---|---|---|---|
| | | WO | 2018050350 A1 | 22-03-2018 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B

- US 13033135 B
- US 13533110 B
- US 13891410 B
- WO 2011012624 A
- US 20160161863 A
- US 20160370717 A1
- US 2007224518 A
- US 2019003988 A1
- US 2019215940 A1
- US 20130304424 A1
- US 2014019097 A1, Bakeman
- US 20170184981 A1
- US 2016282282 A1
- WO 2019238382 A

**Non-patent literature cited in the description**

- **LEMAILLET et al.** Intercomparison between optical and X-ray scatterometry measurements of FinFET structures. *Proc. of SPIE,* 2013, 8681

- **ZHANG et al.** *Noncollinear enhancement cavity for record-high out-coupling efficiency of an EUV frequency comb,* 2020